# EUROPEAN PATENT APPLICATION

(11) **EP 2 827 381 A1**
(43) Date of publication of application: **21.01.2015**
(21) Application number: 13197562.5
(22) Date of filing: 16.12.2013
(51) Int. Cl.: H01L 31/048

(54) **Sealing member, device comprising the same and method of fabricating said device**

(30) Priority: 18.07.2013 US 201361847965 P; 13.11.2013 US 201314079562
(71) Applicant: Samsung SDI Co., Ltd., Yongin-si, Gyeonggi-do (KR)
(72) Inventor: Lee, Jong-Chul, Gyeonggi-do (KR); Jung, Chan-Yoon, Gyeonggi-do (KR); Kang, Yoon-Mook, Gyeonggi-do (KR); Choi, Yong-Mo, Gyeonggi-do (KR); Lee, Seung-Hee, Gyeonggi-do (KR); Lee, Jae-Hoon, Gyeonggi-do (KR); Baek, Do-Hyun, Gyeonggi-do (KR); Im, Jong-San, Gyeonggi-do (KR); Son, Jeong-Ho, Gyeonggi-do (KR); Choi, Sun-Dong, Gyeonggi-do (KR); Hyeon, Soon-Pil, Gyeonggi-do (KR); Kim, Bum-Rae, Gyeonggi-do (KR)
(74) Representative: Granleese, Rhian Jane

(57) **Abstract**

A sealing member for sealing between two substrates, the sealing member comprising at least one plate member formed of a material having elasticity, said at least one plate member being shaped to be resiliently biased along a first axis, such that when compressed along a first axis, the at least one plate member provides a resilient force along said first axis, the sealing member being configured to be located between said substrates such that the resilient force pushes against the substrates.

## Description

### BACKGROUND OF THE INVENTION

### (a) Field of the Invention

The present invention relates to a sealing member. More particularly, the present invention relates to a sealing member sealing between two substrates which may be used in devices such as a display device or a solar cell.

### (b) Description of the Related Art

A solar cell may be defined as an element converting light energy into electrical energy by using a photovoltaic effect in which an electron is generated if light is irradiated to a p-n junction diode. According to a material used for the junction diode, the solar cell may be divided into a silicon solar cell, a compound semiconductor solar cell using a I-III-VI group compound or a III-V group compound, a dye response solar cell, and an organic material solar cell.

Further, an organic light emitting diode display is a self-emitting type of display device having an organic light emitting diode and displaying an image.

This solar cell and this organic light emitting display device include a material that is vulnerable to moisture and oxygen such that cycle-life and reliability of the solar cell and the organic light emitting display device are reduced when they are exposed to moisture and oxygen.

Accordingly, to remove the moisture, a moisture absorbent of various shapes is added before the sealing, however the moisture is not completely prevented and the moisture penetrates inside the solar cell.

The above information disclosed in this Background section is only for enhancement of understanding of the background of the invention and therefore it may contain information that does not form the prior art that is already known in this country to a person of ordinary skill in the art.

### SUMMARY OF THE INVENTION

Accordingly, the present invention provides a sealing member that prevents penetration of moisture transmitting from the outside and a solar cell including the same.

A sealing member according to an embodiment of the present invention includes a first plate having a predetermined width with a plate shape, and a second plate with a plate shape connected to both ends of the first plate, wherein the first plate and the second plate have the same plate shape and form a closed line.

A sealing member according to another embodiment of the present invention, to seal between a first substrate and a second substrate facing each other, wherein the sealing member includes a first sealing member bent at least once and contacting the first substrate and the second substrate with a plate shape, and a second sealing member or coating component surrounding the first sealing member and combines the first substrate and the second substrate.

According to an embodiment of the present invention, when the sealing member is formed as described above, the penetration of the moisture transmitted from the outside is prevented such that a device such as a solar cell or display device, with improved reliability may be provided.

In a first aspect, the present invention provides a sealing member as recited in claim 1. In a second aspect, the present invention provides a device as recited in clam 10. In a third aspect, the present invention provides a method of fabricating a device as recited in claim 14.

Further embodiments are disclosed in the attached dependent claims.

### BRIEF DESCRIPTION OF THE DRAWINGS

FIG. 1 is a top plan view of a sealing member according to an embodiment of the present invention.
FIG. 2 is a cross-sectional view taken along the line II-II of FIG. 1.
FIG. 3 is a perspective view of a portion A of FIG. 1.
FIG. 4 is a top plan view of a sealing member according to another embodiment of the present invention.
FIG. 5 to FIG. 16 are cross-sectional views of a sealing member according to another embodiments of the present invention.
FIG. 17 is a schematic top plan view of a solar cell according to an embodiment of the present invention.
FIG. 18 is a cross-sectional view taken along the line XVI-XVI of FIG. 17.
FIG. 19 is a flowchart of a manufacturing method of a solar cell according to an embodiment of the present invention.
FIG. 20 is a schematic cross-sectional view of a solar cell according to another embodiment of the present invention.

### DETAILED DESCRIPTION OF THE EMBODIMENTS

Hereinafter, embodiments of the present invention will be described in detail with reference to the attached drawings such that the present invention can be easily put into practice by those skilled in the art. As those skilled in the art would realize, the described embodiments may be modified in various different ways, all without departing from the scope of the present invention as defined by the appended claims.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Now, an embodiment of the present invention will be described with reference to accompanying drawings.

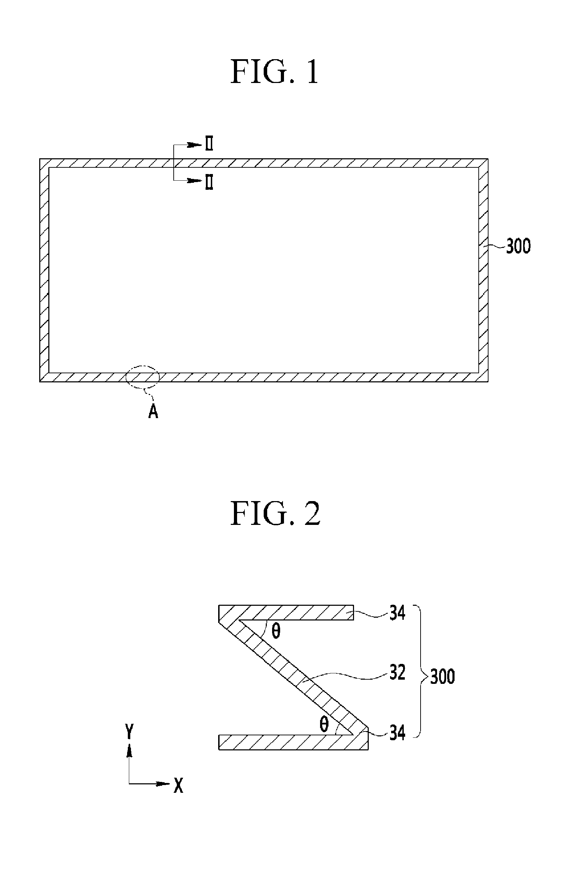

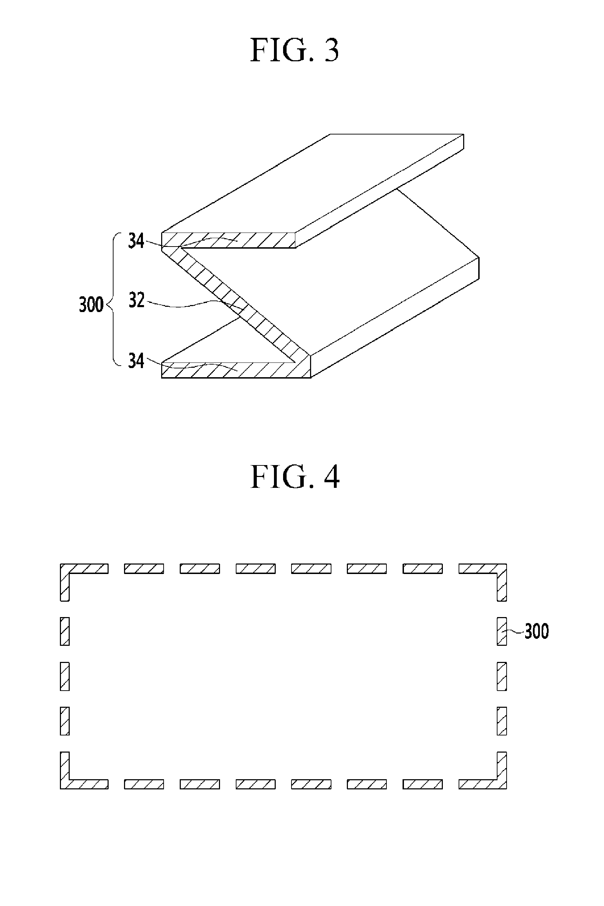

FIG. 1 is a top plan view of a sealing member according to an embodiment of the present invention, FIG. 2 is a cross-sectional view taken along the line 11-11 of FIG. 1, FIG. 3 is a perspective view of a portion A of FIG. 1, and FIG. 4 is a top plan view of a sealing member according to another embodiment of the present invention.

The sealing member 300 may have a flat shape that is bent at least once. The sealing member 300 may be formed of any material having a waterproof function and elasticity, for example, stainless steel, corrosion resistance copper alloys, corrosion resistance aluminum alloys, and corrosion resistance nickel alloys.

The sealing member 300 includes a first plate 32 having a plate shape with a predetermined width, and second plates 34 connected to respective ends of the first plate 32 and having a plate shape with a predetermined width. Each second plate 34 is connected with an angle θ less than 90 degrees with respect to the first plate 32. The second plates 34 positioned at respective sides with respect to the first plate 32 may be parallel to each other.

As shown in FIG. 1, the sealing member 300 may form a integrally closed shape and may be formed by forming a pair of transverse portions and a pair of longitudinal portions and then connecting both ends thereof by welding.

As shown in FIG. 4, a plurality of sealing members 300 may be formed and disposed according to an edge of the substrate. When forming a plurality of sealing members 30 like this, a moisture may penetrate in a region enclosed by the sealing members through spaces between the sealing members such that a liquefied sealing member filling between the sealing members 300 may be added.

If the sealing member 300 is formed as in the present invention, when applying a force to the second plate 34 in a Y-axis direction, the sealing member 300 contracts like a spring and then tends to maintain an original state by the elastic force. It is said to be 'resiliently biased'. If the second plate 34 and the first plate 32 are connected with a 90 angle, when an external force is applied to the second plate 34, it is not easy for the first plate 32 to be bent in any direction such that the elastic force is not generated.

In a sealing member in accordance with an embodiment of the present invention, when forming the sealing member 300 having a plate shape while having the elastic force, the inner moisture penetration from the outside may be easily prevented. That is, if the sealing member 300 is positioned between two substrates, the sealing member 300 and the two substrates come into close contact with each other by the elastic force such that the external moisture does not pass between the second plate and the substrate and does not pass through the first plate 32 and thus it does not penetrated inside. The inside is therefore completely surrounded by the sealing member.

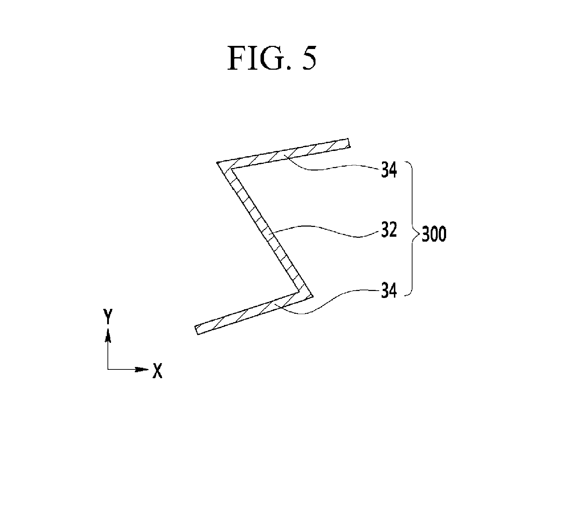

The sealing member according to an embodiment of the present invention may be formed with various shapes as shown in FIG. 5 to FIG. 16.

FIG. 5 to FIG. 16 are cross-sectional views of sealing members according to other embodiments of the present invention.

The sealing members of FIG. 5 to FIG. 16 are sealing members of FIG. 1 to 4 such that the cross-sectional of the sealing member is focused on hereafter.

As shown in FIG. 5, the sealing member 30 may be inclined with respect to the X-axis or the Y-axis. At this time, the angle at which the second plate 34 is inclined with respect to the X-axis may be smaller than the angle at which the second plate 34 is inclined with respect to the Y-axis.

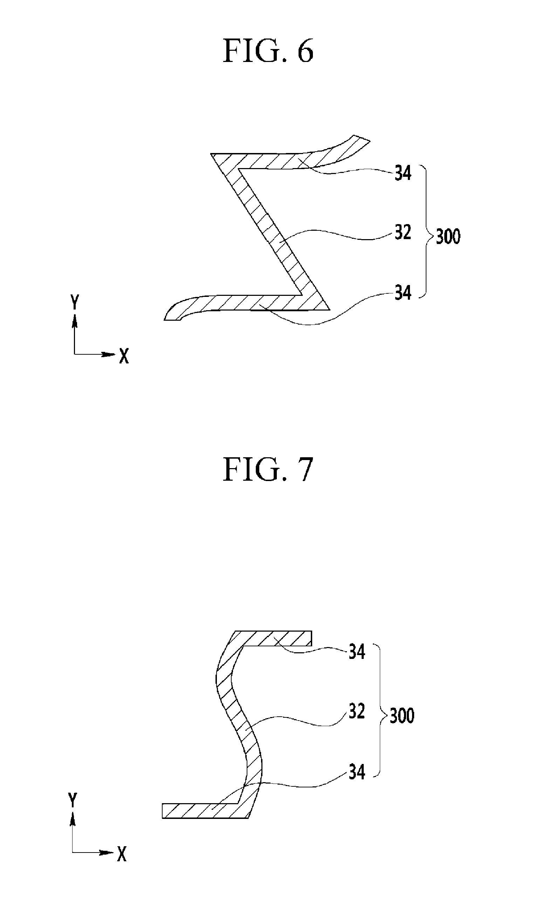

As shown in FIG. 6, the second plates 34 of the sealing member 300 are parallel to each other and may be bent in the Y-axis direction.

The sealing member 300 may be bent such that the first plate 32 may form a smooth curved line as shown in FIG. 7. At this time, the second plates 34 are parallel to each other and parallel to the X-axis. Of course, the second plate 34 of the sealing member 300 of FIG. 6 may also be inclined with respect to the X-axis as shown in FIG. 5 and FIG. 6, and may be bent in the Y-axis direction (not shown).

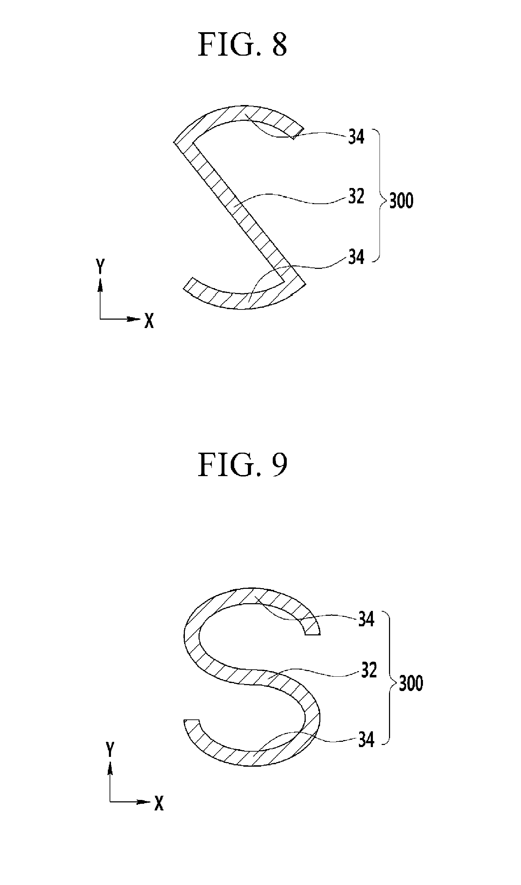

As shown in FIG. 8, the sealing member 300 is bent such that the second plate 34 forms a smooth curved line thereby protruding in the Y-axis direction.

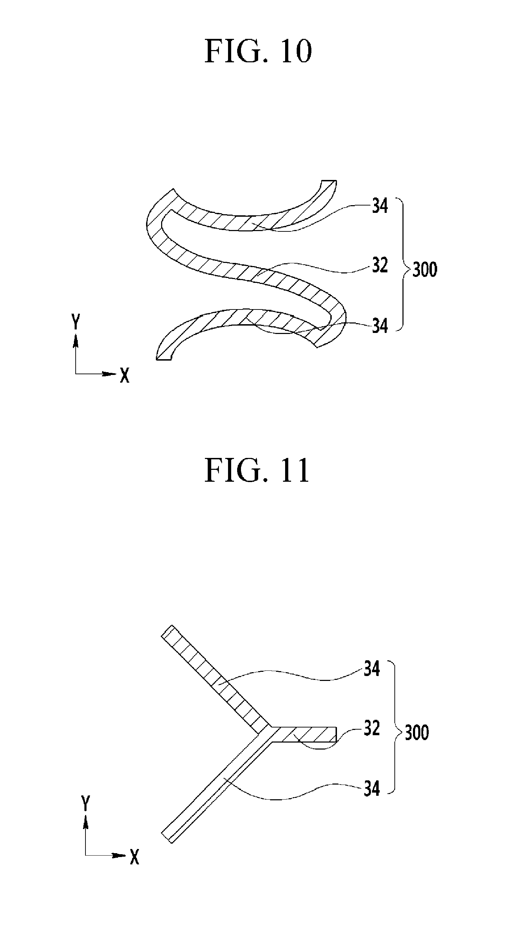

Also, the sealing member 300 may be formed for the first plate 32 and the second plate 34 to be curved, as shown in FIG. 9. In the embodiment of FIG. 8 and 9, the second plates 34 are formed to protrude in opposite directions, however, as shown in FIG. 10, the protruded portions may be formed to face each other.

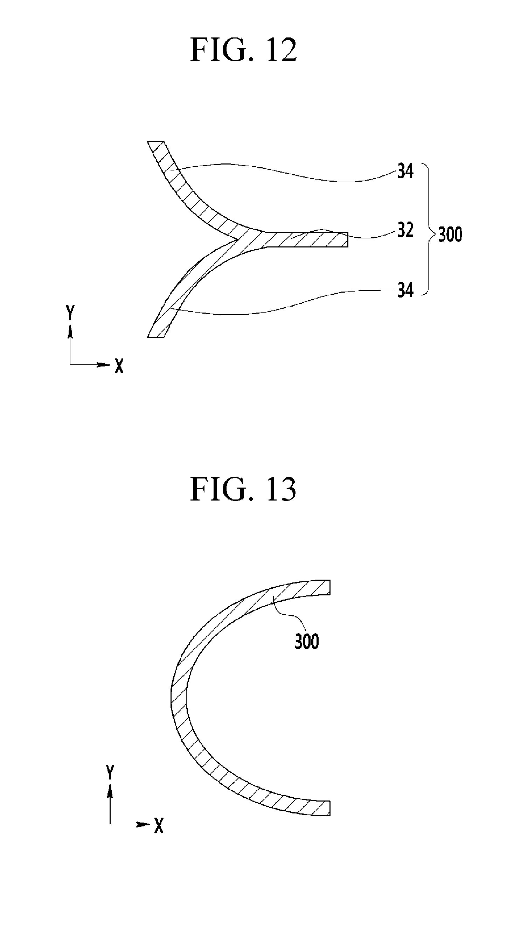

As shown in FIG. 11 and FIG. 12, the sealing member 300 includes the first plate 32 and a pair of the second plates 34 divided from one end of the first plate 32 and extending in the Y-axis and the -Y-axis directions. As shown in FIG. 12, the second plates 34 may be bent.

The sealing member 300 of FIG. 11 and FIG. 12 may be formed by bending or curving one plate to form a pair of second plates and by connecting a first plate to a bent portion of the second plates.

Also, two plates may be provided, and may be bent or curved to have the first and the second plates and the first plates may be connected to each other to form the sealing member 300.

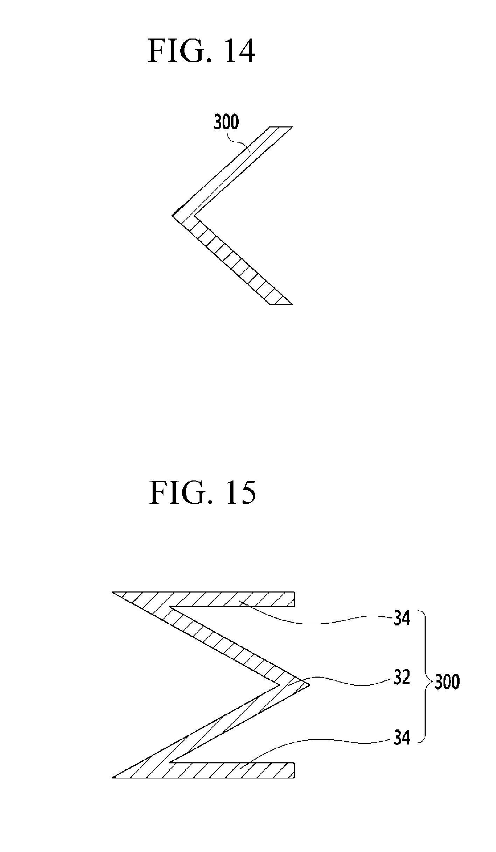

Meanwhile, as shown in FIG. 13, the sealing member may be made of one plate and may be bent, and may be bent one time as shown FIG. 14.

As shown in FIG. 15, the first plate 32 is bent such that the sealing member 300 may have a zigzag shape. In FIG. 15, the first plate 32 is bent once, however it may be bent multiple times. As shown in FIG. 15, if it is formed with the zigzag shape, the number of bent portions is increased such that the elastic force is increased.

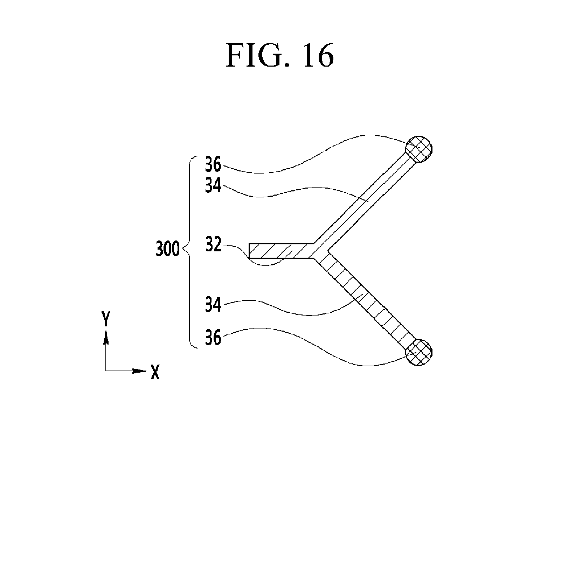

As shown in FIG. 16, in the sealing member 300, an assistance sealing member 36 may be formed at an end of the second plate 34. The assistance sealing member 36 may includes a material having elasticity and an excellent contacting force, for example, a butyl-based resin, an epoxy-based resin, or a silicon-based resin. Also, the assistance sealing member 36 may may be formed of a material having an adhesiveness.

Accordingly, when the sealing member 300 is positioned between two substrates and the end of the second plate contacts the surface of the substrate for sealing the two substrates, the contact area between the second plate and the surface of the substrate is increased such that a sealing force may be increased. That is, if the second plate is formed parallel to the X-axis, the second plate and the substrate surface are surface-contacted, however if the second plate is inclined with respect to the X-axis, the end of the second plate contacts the substrate surface such that the contact area is reduced. Accordingly, if the assistance sealing member is formed, the contact area of the substrate surface of the sealing member is increased such that the sealing force may be improved.

The assistance sealing member of FIG. 16 is formed at the sealing member of FIG. 11, however it may be formed at one end of all sealing members of FIG. 1 to FIG. 15.

In the above embodiment, the first plate 32 and the second plate 34 are divided, however the first plate 32 and the second plate 34 may be formed of one plate to be bent at least once. Of course, an additional plate may be connected by welding.

Next, as shown in FIG. 1 to FIG. 16, the solar cell including the sealing member according to an embodiment of the present invention and a manufacturing method thereof will be described.

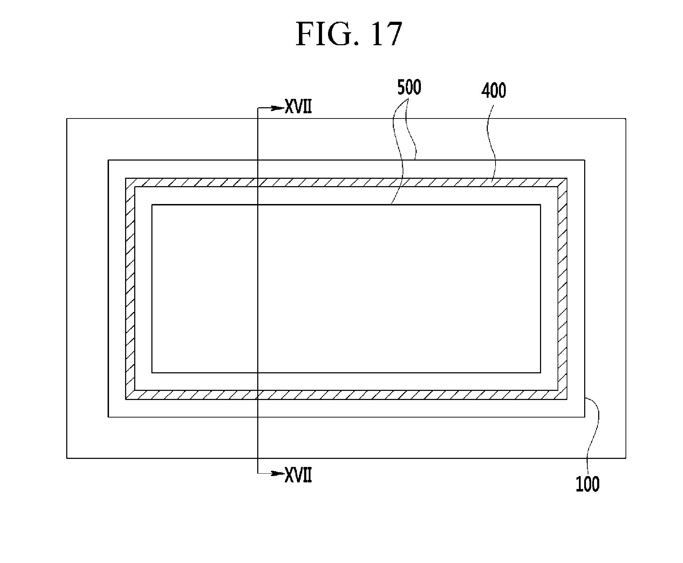

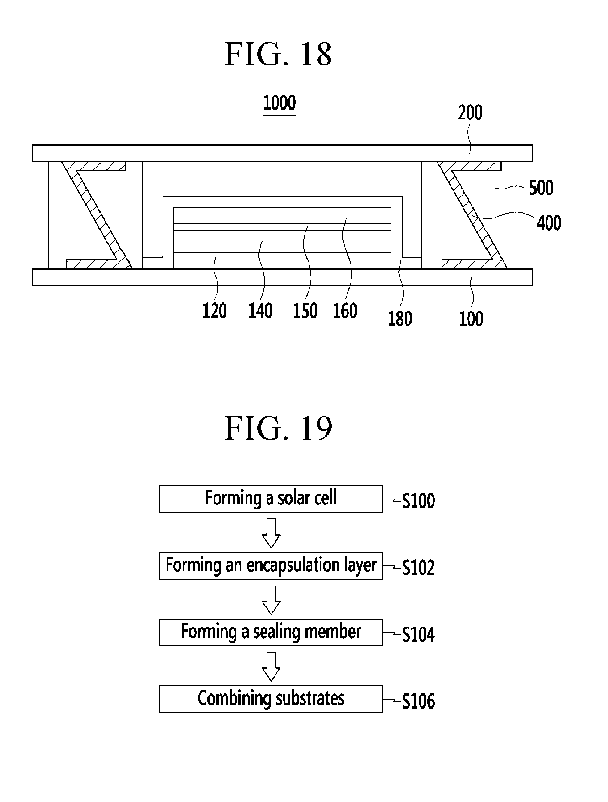

FIG. 17 is a schematic top plan view of a solar cell according to an embodiment of the present invention, and FIG. 18 is a cross-sectional view taken along the line XVIII-XVIII of FIG. 17.

As shown in FIG. 17 and FIG. 18, the solar cell 1000 according to an embodiment of the present invention includes a first substrate 100 and a second substrate 200 facing each other, a (first) sealing member 400 and a second sealing member or coating component 500 sealing between the first substrate 100 and the second substrate 200, and a solar cell positioned between the two sealed substrates and formed on the first substrate 100.

The substrate 100 has an insulating characteristic and may be made of a transparent material such as a soda lime glass. The substrate 100 may include a large amount of sodium (Na).

As shown in FIG. 18, the solar cell includes a first electrode 120 formed on the substrate 100, a photoactive layer 140 formed on the first electrode 120, a buffer layer 150 formed on the photoactive layer, a second electrode 160 formed on the buffer layer 150, and an encapsulation layer 180 formed on the second electrode 160.

At this time, the solar cell is formed of a plurality of unit cells that may be coupled in series or in parallel (not shown).

The first electrode 120 may be formed of a metal having a heat-resistant characteristic, an excellent electrical contact characteristic with the material forming the photoactive layer, excellent electrical conductivity, and excellent interface cohesion with the substrate 100, for example, molybdenum (Mo).

The photoactive layer 140 as a P type CIS-based semiconductor may include selenium (Se) or sulfur (S). For example, the photoactive layer 140 as a I-III-VI-based semiconductor compound may be Cu(In₁₋ₓ,Gaₓ)(Se₁₋ₓ,Sₓ), and may be a compound semiconductor having a composition wherein 0≤x≤1. The photoactive layer 140 may have a single phase in which the composition of the compound semiconductor is substantially uniform. For example, it may be CuInSe₂, CuInS₂, Cu(In,Ga)Se₂, (Ag,Cu)(In,Ga)Se₂, (Ag,Cu)(In,Ga)(Se,S)₂, Cu(In,Ga)(Se,S)₂, or Cu(In,Ga)S₂. Also, the photoactive layer 140 may include sodium (Na) diffused from the substrate 100.

The buffer layer 150 smoothes an energy gap difference between the photoactive layer 140 and the second electrode 150. The buffer layer 150 may be formed of an n-type semiconductor material having high light transmittance, for example, CdS, ZnS, or InS.

The second electrode 160 may be formed of a material having high light transmittance and excellent electrical conductivity, for example, ZnO, and the light transmittance may be more than about 80 %. Also, the ZnO layer is doped with aluminum (AI) or boron (B) thereby having low resistance.

Also, an ITO layer having excellent electrical and light transmittance characteristics may be deposited on the ZnO layer, and the second electrode 160 may be formed of the ITO single layer. Also, an n-type ZnO layer having low resistance may be formed on an i-type ZnO layer that is not doped.

The second electrode 160 as the n-type semiconductor forms a pn junction along with the photoactive layer as the p-type semiconductor.

The encapsulation layer 180 may be formed of a material preventing the moisture and oxygen penetrating, for example, EVA (ethylene vinyl acetate).

The first sealing member 400 may be one among the sealing members of the plate shape having the elastic force shown in FIG. 1 to FIG. 16, and an example of the sealing member of FIG. 2 is described in FIG. 18.

The second plate 34 of the first sealing member 400 is parallel to the first substrate surface and the second substrate surface, and one surface of the second plate 34 and the first substrate surface or the second substrate surface contact each other. When using the sealing member of FIG. 4 to FIG. 14 as the first sealing member, the second plates 34 also contact the first substrate surface and the second substrate surface.

A second sealing member 500 is linearly formed according to the edge of the substrate 100 thereby forming an enclosed curved line. The second sealing member 500 has adherence and contacts the first substrate 100 and the second substrate 200 thereby combining the two substrates. The second sealing member 500 may include a material to be sealed by using visible rays or heat, for example, a butyl-based resin, an epoxy-based resin, or a silicon-based resin.

The plane shapes of the first sealing member 400 and the second sealing member 500 are the same, and the first sealing member 400 is positioned within the boundary of the second sealing member 500. That is, the first sealing member 400 is narrower than the second sealing member 500, and the second sealing member 500 fills the space between the first plate 32 and the second plate 34 of the first sealing member 400 and encloses the first sealing member 400.

The first sealing member 400 has elastic force without the adherence such that it does not combine the two substrates, such that the width of the second sealing member 500 is larger than the width of the first sealing member 400 to contact the two substrates for the combination.

At this time, as shown in FIG. 16, if the assistance sealing member 36 is included and the first sealing member 400 including the assistance sealing member 36 formed of the material having an adhesiveness is formed, a width of the second sealing member 500 may be reduced or the second sealing member 500 may be omitted.

The second substrate 200 to protect the solar cell from physical impacts and foreign materials from the outside may be a tempered glass.

In an embodiment of the present invention, when forming the first sealing member 400 and the second sealing member 500, the penetration of external moisture to the solar cell positioned between the two substrates may be prevented. That is, by the elastic force of the first sealing member 400, the second plates of the first sealing member closely contact the first substrate surface and the second substrate surface. Accordingly, a moisture moving path is eliminated between the first sealing member and the substrate so the external moisture may not move to the inside where the solar cell is positioned.

Meanwhile, the second sealing member 500 has strong adherence such that the first substrate 100 and the second substrate 200 are not separated. Accordingly, the elastic force of the first sealing member 400 must be smaller than the adherence of the second sealing member 500 such that the first substrate 100 and the second substrate 200 may be not separated by the elastic force of the first sealing member 400.

The adherence of the second sealing member 500 may be reduced, for example, to 1/10 compared with initial adherence such that the elastic force of the first sealing member 400 with respect to that of the second sealing member 500 is preferably less than 1/10 of the adherence by considering the reduced adherence.

Next, a method of forming the solar cell of FIG. 17 and FIG. 18 will be described with reference to FIG. 19 as well as FIG. 18.

FIG. 19 is a flowchart of a manufacturing method of a solar cell according to an embodiment of the present invention.

As shown in FIG. 19, the method includes providing the first substrate and forming a solar cell on the first substrate (S100), forming an encapsulation layer on the solar cell (S102), forming a sealing member on the first substrate (S104), and aligning and combining the second substrate (S106).

In the forming of the solar cell on the first substrate (S100), the solar cell shown in FIG. 18 may be manufactured by a general method, and a deposition structure thereof is not limited thereto and may be various.

In the forming of the encapsulation layer on the solar cell (S102), the encapsulation layer covers the entire solar cell and may be made of the EVA.

In the forming of the sealing member on the first substrate (S104), the second sealing member in a solution state is coated according to the edge of the first substrate to enclose the solar cell on the first substrate 100.

The first sealing member 400 is also disposed on the second sealing member 500. The first sealing member 400 may one among the sealing members shown in FIG. 1 to FIG. 14.

At this time, the second sealing member 500 may be formed by only one coating to sufficiently enclose the first sealing member 400. Meanwhile, the second sealing member may be coated twice. After forming the second sealing member 500 by coating once, if the first sealing member 400 is disposed, a pressing process is required to completely insert the second sealing member 500 inside the first sealing member 400.

However, if the second sealing member 500 is coated twice, the pressing process to insert the first sealing member 400 may be omitted.

That is, if a portion of the entire required amount of the second sealing member 500 is coated and then the first sealing member 400 is disposed, a thickness of the second sealing member 500 is not high such that the first sealing member 400 may be inserted to the second sealing member500. Also, even if the first sealing member 400 is not inserted, the rest of the second sealing member 500 is coated on the first sealing member 400 such that the second sealing member 500 may be formed to completely enclose the first sealing member 400.

Although the second sealing member 500 is coated on the first sealing member 400, the second sealing member 500 positioned between the substrate surface and the second plate is pushed out by the later pressing process such that the second plate of the first sealing member 400 and the substrate surface may fully contact.

In the aligning and combining of the second substrate 200 (S106), the second substrate 200 is disposed and aligned on the sealing member 400 and 500 to face the first substrate.

Next, the second substrate 200 is pressed to contact the first sealing member 400 with the first substrate 100 and the second substrate 200, and then the first substrate 100 and the second substrate 200 are completely sealed by hardening the second sealing member 500 thereby completing the solar cell.

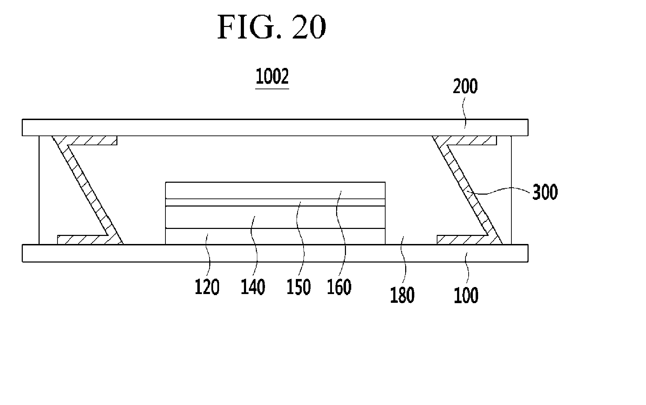

FIG. 20 is a schematic cross-sectional view of a solar cell according to another embodiment of the present invention.

Most of the interlayer configuration is equivalent to that described with reference to FIG. 17 and FIG. 18, so no repeated description will be provided.

A solar cell 1002 of FIG. 20 includes the first substrate 100 and the second substrate 200 facing to each other, the sealing member 300 sealing the space between the first substrate 100 and the second substrate 200, and cells positioned between the first substrate 100 and the second substrate 200 and formed on the first substrate 100.

In the solar cell of FIG. 20, the encapsulation layer 180 is formed till a peripheral area (or an edge of the substrate of the solar cell) as well as an area where the cells are positioned, and the second substrate 200 is contacted with the encapsulation layer 180. Like this, if the encapsulation layer 180 is formed till the peripheral area, the second sealing member may be omitted differently from FIG. 18 as the encapsulation layer 180 forms the coating component of the first sealing member. That is, the encapsulation layer 180 of the solar cell is formed till the peripheral area of the cells, and one sealing member among FIG. 1 to FIG. 16 is disposed, the second substrate 200 is aligned and thermo-compressed, and then the encapsulation layer is hardened for sealing.

In the above embodiment, the solar cell is described as an example, however any organic light emitting display device including the organic light-emitting device may be sealed by using the sealing member like an embodiment of the present invention. That is, the organic light emitting display device includes the organic light-emitting device positioned on the substrate and forming a matrix, a plurality of signal lines connected to the organic light emitting light-emitting device, and thin film transistors. The sealing member is formed on the substrate and protects the organic light emitting light-emitting device along with an opposing substrate from external moisture.

While this invention has been described in connection with practical embodiments, it is to be understood that the invention is not limited to the disclosed embodiments, but, on the contrary, is intended to cover various modifications and equivalent arrangements included within the scope of the appended claims.

**<Description of Symbols>**

| | | | |
|---|---|---|---|
| 32: first plate | 34: second plate | | |
| 36: assistance sealing member | 100: first substrate | | |
| 120: first electrode | | 140: photoactive | |
| 150: buffer layer | | 160: second electrode | |
| 180: encapsulation layer | 200: second substrate | | |
| 300: sealing member | 400: first sealing member | | |
| 500: second sealing member | | | 1000: solar cell |

## Claims

1. A sealing member (300, 400) for sealing between two substrates (100, 200), the sealing member comprising at least one plate member (32, 34) formed of a material having elasticity, said at least one plate member (32, 34) being shaped to be resiliently biased along a first axis, such that when compressed along a first axis, the at least one plate member (32, 34) provides a resilient force along said first axis, the sealing member (300, 400) being configured to be located between said substrates (100, 200) such that the resilient force pushes against the substrates (100, 200).

2. A sealing member according to claim 1, wherein the sealing member (300, 400) comprises a coating component (500) configured surround said at least one plate member (32, 34) and combine the two substrates (100, 200).

3. A sealing member according to claim 2, wherein the two substrates (100, 200) are adhered together by said coating component (500) and the resilient force provided along the first axis is less than the force required to overcome the adherence of the two substrates (100, 200) by said coating component (500).

4. A sealing member according to any preceding claim, wherein the at least one plate member (32, 34) comprises at least two portions (32, 34) which are connected such that they are forced apart when compressed along the first axis.

5. A sealing member according to any preceding claim, wherein the at least one plate member (32, 34) comprises a plurality of plate members in a folded configuration wherein a join between two plate members is provided at a fold.

6. A sealing member according to any of claims 1 to 3, wherein the at least one plate member is a single plate which is bent over such that it provides a resilient force when compressed along a first axis.

7. A sealing member according to any preceding claim, wherein said at least one plate member (32, 34) is curved.

8. A sealing member according to any preceding claim, wherein the at least one plate member (32, 34) forms a branched structure, configured such that at least two branches serve to provide the resilient force along the first axis.

9. A sealing member according to any preceding claim, further comprising at least one assistance sealing member (36), said assistance sealing member (36) being located between the plate member (32, 34) and said substrates (100, 200).

10. A device comprising a device unit (120, 140, 150, 160), first (100) and second (200) substrates and a sealing member, wherein said device unit (120, 140, 150, 160) is located between the first (100) and second (200) substrates and said sealing member is a sealing member as recited in any preceding claim.

11. A device according to claim 10, wherein said sealing member (300, 400, 500) is continuous and provides a perimeter around said device unit (120, 140, 150, 160) in a plane parallel to the first (100) and second (200) substrates.

12. A device according to claim 10, wherein said sealing member (300, 400, 500) provides a non-continuous perimeter around said device unit (120, 140, 150, 160) in a plane parallel to the first (100) and second (200) substrates, a further sealing member sealing any gaps in said perimeter.

13. A device according to any of claims 10 to 12, wherein the device unit (120, 140, 150, 160) comprises a solar cell or a display device.

14. A method of fabricating a device,
forming a device unit (120, 140, 150, 160) on a first substrate (100),
disposing a sealing member (300, 400) on said first substrate, said first sealing member (300, 400) being provided in a perimeter around said device unit (120, 140, 150, 160);
coating said sealing member (300, 400) with a coating component (500); and providing a second substrate (200) on said first sealing member (300, 400), wherein said sealing member (300, 400) comprises at least one plate member (32, 34) formed of a material having elasticity, said at least one plate member (32, 34) being shaped to be resiliently biased along a first axis, such that when compressed along a first axis, the at least one plate member (32, 34) provides a resilient force along said first axis, the sealing member (300, 400) being configured to be located between the first (100) and second (200) substrates such that the resilient force pushes against the substrates (100, 200).
